(19) Europäisches Patentamt
European Patent Office
Office européen des brevets

(11) **EP 3 079 940 B1**

(12) **FASCICULE DE BREVET EUROPEEN**

(45) Date de publication et mention
de la délivrance du brevet:
**11.04.2018 Bulletin 2018/15**

(21) Numéro de dépôt: **14821777.1**

(22) Date de dépôt: **02.12.2014**

(51) Int Cl.:
*B60L 3/12* *(2006.01)*     *B60L 11/18* *(2006.01)*
*G01R 31/00* *(2006.01)*     *G01R 31/36* *(2006.01)*

(86) Numéro de dépôt international:
**PCT/FR2014/053121**

(87) Numéro de publication internationale:
**WO 2015/086952 (18.06.2015 Gazette 2015/24)**

(54) **EVALUATION DE LA QUANTITE D'ENERGIE DANS UNE BATTERIE DE VEHICULE AUTOMOBILE**

BEURTEILUNG DER ENERGIEMENGE BEI EINER KRAFTFAHRZEUGBATTERIE

ASSESSING THE QUANTITY OF ENERGY IN A MOTOR VEHICLE BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.12.2013 FR 1362491**

(43) Date de publication de la demande:
**19.10.2016 Bulletin 2016/42**

(73) Titulaire: **Renault S.A.S.**
**92100 Boulogne-Billancourt (FR)**

(72) Inventeurs:
• **LEIRENS, Sylvain**
**38119 Pierre-Chatel (FR)**
• **LALLICH, Sylvain**
**38250 Lans-en-Vercors (FR)**

(56) Documents cités:
**EP-A2- 2 669 695**     **WO-A1-2012/169063**
**US-A1- 2013 041 538**

**Description**

L'invention concerne le contrôle d'une batterie de véhicule automobile. L'invention concerne en particulier l'évaluation de l'énergie disponible ou extractible (en anglais « Available Energy ») dans une batterie de véhicule automobile notamment un véhicule électrique ou hybride. L'invention concerne également l'évaluation de la quantité d'énergie à accumuler lors d'une phase de charge de la batterie.

Pour un état de charge ou SOC (de l'anglais « State of Charge ») donné, l'énergie extractible d'une batterie est fonction de la température. En effet, plus la température de batterie est faible, plus les résistances internes de la batterie sont élevées. Pour un même niveau de courant, la tension moyenne peut devenir plus faible pendant l'ensemble de la décharge.

Il est connu d'équiper les véhicules automobiles de systèmes de gestion de batterie, par exemple de BMS (de l'anglais « Batterie Management System »), permettant entre autres d'évaluer l'énergie disponible. Le calcul de cette énergie disponible nécessite de connaître la capacité (en Ah) de la batterie, sa résistance interne et la tension en circuit ouvert (OCV) de la batterie en fonction de l'état de charge. Or, la capacité et la résistance interne de la batterie sont des caractéristiques qui évoluent au cours de la durée de vie de la batterie. La précision de détermination de la quantité d'énergie disponible est ainsi liée à la connaissance de ces valeurs, qui sont cependant généralement approximées par des cartographies nécessitant une importante quantité d'essais pour leur réalisation. Le document US 2013/041538 A1 décrit un procédé d'évaluation d'une quantité d'énergie à puissance constante d'une batterie de véhicule automobile.

Le document US 2006/202663 A1 décrit un procédé pour estimer la capacité résiduelle d'une batterie, dans lequel on détermine une valeur initiale du SOC en tenant compte de la variation de la tension en circuit ouvert en fonction de la température et du vieillissement de la batterie. A cet effet, une cartographie du SOC en fonction de la température et de la tension en circuit ouvert est établie et enregistrée dans le BMS, puis une mesure de la température et de la tension au circuit ouvert permet de déterminer une valeur initiale de SOC. Ce procédé ne permet cependant pas de tenir compte de l'évolution dans le temps de la résistance interne ni de la capacité de la batterie. En outre, la valeur mesurée de l'OCV servant à la détermination de la valeur initiale de SOC peut être erronée si la batterie n'est pas dans un état suffisamment relaxé, conduisant à une mauvaise estimation de la valeur initiale de SOC.

Il existe donc un besoin pour une évaluation plus précise de la quantité d'énergie d'une batterie, permettant notamment une mise à jour d'au moins une partie des paramètres au cours du vieillissement de la batterie.

Il est proposé un procédé d'évaluation d'une quantité d'énergie à puissance constante d'une batterie de véhicule automobile, ladite quantité d'énergie correspondant à une quantité d'énergie extractible ou à une quantité d'énergie à accumuler, ledit procédé comprenant :

(a) déterminer une valeur d'un paramètre de capacité Q de la batterie,

(b) construire, notamment pendant une phase de charge de la batterie, une table de valeurs d'un paramètre de tension aux bornes de la batterie en fonction de la valeur d'un paramètre de courant pour N valeurs d'un paramètre d'état de charge ($z$),

(c) déterminer une valeur d'un paramètre de résistance interne $R(z)$ de la batterie en fonction dudit paramètre d'état de charge ($z$) de ladite batterie à partir de la table construite à l'étape (b),

(d) prévoir une table de valeurs d'un paramètre de tension en circuit ouvert $Uoc(z)$ de la batterie en fonction du paramètre d'état de charge ($z$) de la batterie,

(e) estimer une valeur du paramètre d'état de charge ($z_0$) de la batterie à un instant initial $t_0$, correspondant à un état de charge initial de la batterie,

(f) estimer par calcul une valeur de paramètre de quantité d'énergie $E_p$ entre un état de charge final et ledit état de charge initial en utilisant une fonction $f(z)$ dont la variable est le paramètre d'état de charge ($z$) et dont les paramètres sont ladite valeur du paramètre de capacité $Q$ de la batterie, ladite valeur du paramètre de résistance interne $R(z)$ et ladite valeur de la tension en circuit ouvert $Uoc(z)$.

On pourra prévoir de transmettre vers une interface utilisateur un signal élaboré en fonction de la quantité d'énergie ainsi estimée.

Les étapes de détermination des valeurs de paramètres de capacité $Q$ et de résistance interne $R(z)$ permettent une mise à jour régulière de ces valeurs au cours du vieillissement de la batterie et par conséquent une prise en compte de ce vieillissement dans le calcul d'estimation de la quantité d'énergie, ce qui peut permettre d'améliorer la précision de ces valeurs et par conséquent la précision du calcul d'estimation de la quantité d'énergie.

L'étape (a) peut ainsi être réitérée régulièrement au cours de la vie de la batterie, notamment indépendamment de la mise en oeuvre des autres étapes. Autrement dit, la valeur de paramètre de capacité déterminée à l'étape (a) peut être utilisée pour plusieurs réitérations des autres étapes. La réitération de l'étape (a) peut être prévue à des intervalles de temps prédéterminés ou quand certaines conditions d'utilisation sont remplies, par exemple lors d'une phase de charge totale de la batterie, après un nombre prédéterminé de cycles de charge/décharge, après un certain kilométrage effectué ou autre.

La valeur du paramètre de capacité $Q$ déterminée à l'étape (a) peut être déterminée par comptage de la quantité de courant traversant la batterie lors d'une phase de charge de celle-ci. Avantageusement, cette détermination peut être effectuée lors d'une phase de charge totale de la batterie, mais une détermination pendant une phase de charge partielle est également possible.

Le paramètre de capacité $Q$ peut être une valeur de capacité, un paramètre ayant une valeur proportionnelle à la valeur de la capacité ou autre.

L'étape (b) de construction d'une table peut également être réitérée régulièrement au cours de la vie de la batterie, notamment indépendamment de la mise en oeuvre des autres étapes, en particulier indépendamment de la réitération de l'étape (a) et des étapes (e) et (f).

Le paramètre d'état de charge ($z$) peut être le SOC, un paramètre permettant de déterminer le SOC, ou autre.

Les N valeurs du paramètre d'état de charge peuvent être échelonnées entre une valeur minimale d'état de charge correspondant à un état de charge minimum atteignable (batterie complètement vide) et une valeur maximale d'état de charge correspondant à un état de charge maximal atteignable (batterie complètement chargée). A titre d'exemple, le nombre N peut être inférieur ou égal à 25, de préférence inférieur à 20, par exemple égal à 10, et de préférence supérieur ou égal à 9.

Le paramètre représentatif d'un courant peut par exemple être une valeur de courant, un paramètre ayant une valeur proportionnelle à la valeur du courant, ou autre. Le paramètre représentatif de la tension aux bornes de la batterie peut par exemple être une valeur de tension, un paramètre ayant une valeur proportionnelle à la valeur de la tension, ou autre. L'invention n'est en rien limitée à la nature exacte de ces paramètres.

Cette étape de construction (b) peut être réalisée lors d'une phase de charge de la batterie, par exemple en mesurant la valeur du paramètre de tension et la valeur du paramètre de courant (courant de charge) pour différents états de charge de la batterie.

En prévoyant de déterminer la valeur d'un paramètre de résistance interne $R(z)$ de la batterie en fonction de l'état de charge ($z$) à partir d'une table de valeur construite et non d'une cartographie, le procédé selon l'invention peut permettre une détermination plus précise de cette résistance interne au cours du vieillissement de la batterie.

Au cours de l'étape (d), la table des valeurs $Uoc(z)$ en fonction du paramètre d'état de charge ($z$) de la batterie peut être obtenue à partir de la table construite à l'étape (b), la valeur du paramètre de tension en circuit ouvert pouvant être déterminée lorsque la valeur du paramètre de courant est nulle et la batterie relaxée. Notamment, $Uoc(z)$ peut être approché par un polynôme d'ordre inférieur ou égal à N-1 à partir des N valeurs de la table, approximation par exemple par un polynôme au sens des moindres carrés. D'autres approximations sont toutefois envisageables, telles que l'interpolation linéaire ou non, de préférence linéaire. En outre, cette table pourrait également être une table établie préalablement, notamment par des mesures expérimentales, et enregistrée, par exemple sous forme de cartographie.

L'état de charge initial est un état de charge à un instant $t_0$ initial correspondant à un instant de début de mission, par exemple au démarrage du véhicule ou à un instant au cours du roulage du véhicule.

Avantageusement et de manière non limitative, l'étape (e) d'estimation de la valeur du paramètre d'état de charge initial ($z_0$) peut comprendre, à l'instant initial $t_0$ :

(i) mesurer la valeur du paramètre de tension aux bornes de la batterie et la valeur du paramètre de courant circulant dans la batterie lorsque ladite valeur du paramètre de courant est stable pendant une durée prédéterminée au cours d'une phase de décharge de la batterie,

(ii) en déduire la valeur du paramètre d'état de charge initial ($z_0$) à partir de la table construite à l'étape (b).

Ladite valeur du paramètre de courant est dite stable lorsqu'elle ne varie pas pendant une durée prédéterminée ou lorsqu'elle varie peu. A titre d'exemple, on peut considérer que la valeur du paramètre de courant varie peu lorsqu'elle ne varie pas de plus de 10% à 20%, par exemple pas de plus de 15%, par rapport à sa valeur moyenne pendant la durée prédéterminée, par exemple de 10s. Bien entendu, l'invention n'est pas limitée par la durée prédéterminée, ni par le pourcentage de variation.

L'invention n'est toutefois pas limitée par cette méthode de détermination du paramètre d'état de charge à partir de la table construite à l'étape (b) et d'autres méthodes pourraient être utilisées.

Avantageusement et de manière non limitative, l'étape (e) peut comprendre les étapes supplémentaires suivantes :

(iii) estimer une deuxième valeur du paramètre d'état de charge initial ($z'_0$) par une autre méthode de prédiction,

(iv) comparer la première valeur du paramètre d'état de charge initial ($z_0$) déterminée à l'étape (ii) avec la deuxième valeur du paramètre d'état de charge initial ($z'_0$) déterminée à l'étape (iii),

(v) utiliser la valeur du paramètre d'état de charge initial ($z_0$) déterminée à l'étape (ii) si la différence $z_0 - z'_0$ est inférieure à une valeur prédéterminée, sinon, utiliser la deuxième valeur du paramètre d'état de charge initial ($z'_0$)

déterminée à l'étape (iii).

Cet enchainement peut permettre d'améliorer la détermination de la valeur du paramètre d'état de charge initial en comparant les valeurs estimées au moyen de deux méthodes différentes.

Notamment, l'étape (iii) peut utiliser une méthode de prédiction basée sur un comptage coulombique.

L'étape (f) d'estimation par calcul d'une valeur de paramètre de quantité d'énergie $E_p$ entre un état de charge final et ledit état de charge initial est mise en oeuvre en utilisant une fonction $f(z)$ dont la variable est le paramètre d'état de charge $(z)$. Cette formulation permet de simplifier les calculs, la quantité d'énergie étant alors estimée entre une valeur de paramètre d'état de charge initial et une valeur de paramètre d'état de charge final. Cette étape (f) d'estimation est mise en oeuvre pour une valeur d'un paramètre de puissance prédéterminée. Cette valeur de paramètre de puissance peut être une valeur de puissance, un paramètre proportionnel à la valeur de puissance ou autre. La valeur de paramètre de puissance prédéterminée peut correspondre à une valeur prévue d'utilisation de la batterie.

Le paramètre de quantité d'énergie $E_p$ peut être une valeur de quantité d'énergie, un paramètre proportionnel à la valeur de quantité d'énergie ou autre.

L'état de charge final est un état de charge à un instant final $t_f$ correspondant à un instant ultérieur à l'instant initial.

L'état de charge final peut notamment être défini comme l'état de charge atteint pour une valeur seuil de paramètre tension $U_{final}$ prédéterminée aux bornes de la batterie.

Notamment, le paramètre d'état de charge final $(z_f)$ peut ainsi être obtenu en résolvant l'équation suivante :

$$U_{final} = Uoc(z_f) + R(z_f)\frac{P}{U_{final}} \qquad (1)$$

Où $Uoc(z_f)$ est la valeur du paramètre de tension en circuit ouvert de la batterie à l'état de charge final, $R(z_f)$ est la résistance interne de la batterie à l'état de charge final et $P$ est la valeur du paramètre de puissance considérée.

$Uoc(z)$ peut être déterminé à partir de la table de l'étape (d) du procédé, notamment par les méthodes décrites plus haut.

$R(z_f)$ peut être déterminé à partir de la table de l'étape (c) du procédé.

Lorsque le procédé est utilisé pour déterminer une quantité d'énergie extractible de la batterie, notamment lors d'une phase de décharge de la batterie, la valeur seuil du paramètre de tension $U_{final}$ peut être définie comme une valeur minimale autorisée de la batterie.

Lorsque le procédé est utilisé pour déterminer une quantité d'énergie restant à accumuler dans la batterie, notamment lors d'une phase de charge de la batterie, la valeur seuil du paramètre de tension $U_{final}$ peut être définie comme une valeur maximale à atteindre ou atteignable.

Avantageusement et de manière non limitative, la fonction $f(z)$ utilisée dans l'étape (f) d'estimation de la quantité d'énergie peut s'écrire :

$$f(z) = Uoc(z) + \sqrt{\Delta(z)} \qquad (2),$$

dans laquelle :

$\Delta(z)$ est un terme prenant en compte les pertes d'énergie, fonction de la valeur du paramètre d'état de charge $(z)$, $Uoc(z)$ représente le paramètre de tension en circuit ouvert en fonction de la valeur du paramètre d'état de charge $(z)$. La valeur du paramètre de quantité d'énergie est alors obtenue par intégration de cette fonction $f(z)$ entre la valeur du paramètre d'état de charge à l'état initial $(z_0)$ et la valeur du paramètre d'état de charge à l'état final $(z_f)$, ladite valeur du paramètre d'état de charge final $(z_f)$ étant la solution de l'équation (1) sus mentionnée.

En particulier, la fonction $f(z)$ peut être approximée par un polynôme d'ordre n inférieur ou égal à N-1. La valeur de paramètre de quantité d'énergie $E_p$ peut alors être exprimée par :

$$E_P \approx \frac{Q}{2}\left(r(z_f) - r(z_0)\right) \qquad (3).$$

où $r(z)$ est l'intégrale dudit polynôme d'ordre n, $Q$ représente le paramètre de capacité.

Avantageusement et de manière non limitative, le procédé peut comprendre, après l'étape (f), l'étape suivante :

(g) déterminer une nouvelle valeur du paramètre d'état de charge initial ($z''_0$) en utilisant la valeur de paramètre de quantité d'énergie $E_p$ estimée à l'étape (f).

La nouvelle valeur du paramètre d'état de charge initial ($z''_0$) déterminée au cours de l'étape (g) susmentionnée peut être utilisée pour la mise en oeuvre de l'étape (f) pour une autre valeur de paramètre de puissance $P$. Autrement dit, les étapes (e) à (f) peuvent être mises en oeuvre pour une première valeur de paramètre de puissance $P_1$, puis l'étape (f) peut être mise en oeuvre pour une deuxième valeur de paramètre de puissance $P_2$ (différente de $P_1$) en utilisant la valeur du paramètre d'état de charge initial ($z''_0$) déterminée à l'étape (g).

Tel que déjà mentionné, la valeur du paramètre de puissance $P$ utilisé pour le calcul des étapes (e) et (f) peut faire partie d'un ensemble de valeurs prédéterminées utilisables, correspondant par exemple à des puissances de décharge représentatives d'usages du véhicule ou à des puissances de charge. Il peut ainsi être utile d'estimer la quantité d'énergie $E_p$ pour différentes valeurs de paramètre de puissance $P$. Ces estimations peuvent être obtenues en réitérant les étapes (e) et (f) pour différentes valeurs de paramètre de puissance $P$.

Il est en outre proposé un dispositif d'évaluation d'une quantité d'énergie d'une batterie de véhicule automobile à puissance constante, ladite quantité d'énergie correspondant à une quantité d'énergie extractible ou à une quantité d'énergie à accumuler. Ce dispositif comprend :

- des moyens de réception aptes à recevoir différentes valeurs de paramètres dont une valeur d'un paramètre de tension aux bornes de la batterie, une valeur d'un paramètre de courant, et éventuellement une valeur de paramètre de temps,
- des moyens agencés pour stocker les valeurs reçues par les moyens de réception et stocker une table de valeurs d'un paramètre de tension aux bornes de la batterie en fonction de la valeur d'un paramètre de courant, pour N valeurs d'un paramètre d'état de charge ($z$) de ladite batterie et une table de valeurs d'un paramètre de tension en circuit ouvert $Uoc(z)$ de la batterie en fonction du paramètre d'état de charge ($z$) de la batterie,
- des moyens de traitement agencés pour

  - déterminer une valeur d'un paramètre de capacité $Q$ de la batterie,
  - construire une table de valeurs d'un paramètre de tension aux bornes de la batterie en fonction de la valeur d'un paramètre de courant pour N valeurs d'un paramètre d'état de charge ($z$) de ladite batterie,
  - déterminer une valeur d'un paramètre de résistance interne $R(z)$ de la batterie en fonction dudit paramètre d'état de charge ($z$) de ladite batterie à partir de la table construite,
  - estimer une valeur du paramètre d'état de charge ($z_0$) de la batterie à un instant initial $t_0$, correspondant à un état de charge initial de la batterie, notamment en fonction de la table stockée dans les moyens de stockage, et
  - estimer par calcul une valeur de paramètre de quantité d'énergie $E_p$ entre un état de charge final et ledit état de charge initial en utilisant une fonction $f(z)$ dont la variable est le paramètre d'état de charge ($z$) et dont les paramètres sont ladite valeur du paramètre de capacité $Q$ de la batterie, ladite valeur du paramètre de résistance interne $R(z)$ et ladite valeur de la tension en circuit ouvert $Uoc(z)$.

Le dispositif peut en outre comprendre des moyens de transmission agencés pour transmettre vers une interface utilisateur un signal élaboré en fonction de la valeur de quantité d'énergie ainsi estimée.

Il est en outre proposé un système de gestion de batterie de véhicule automobile, par exemple un BMS ou autre, intégrant un tel dispositif.

Ce système et/ou ce dispositif peuvent comprendre ou être intégrés dans un ou plusieurs processeurs, par exemple des microcontrôleurs, des microprocesseurs ou autres.

Les moyens de réception peuvent comprendre une broche d'entrée, un port d'entrée ou autre. Les moyens de mémorisation peuvent comprendre une mémoire RAM (de l'anglais « Random Access Memory »), une EEPROM (de l'anglais « (Electrically-Erasable Programmable Read-Only Memory »), ROM (de l'anglais « Read-Only Memory) ou autre. Les moyens de traitement peuvent par exemple comprendre un coeur de processeur ou CPU (de l'anglais « Central Processing Unit »). Les moyens de transmission peuvent par exemple comprendre un port de sortie, une broche de sortie ou autre.

Il est en outre proposé un véhicule automobile comprenant un système de gestion de batterie tel que décrit ci-dessus, et comprenant éventuellement une batterie. Ce véhicule peut par exemple être un véhicule électrique et/ou hybride.

Il est en outre proposé un produit programme d'ordinateur comprenant les instructions pour effectuer les étapes du procédé décrit ci-dessus lorsque ces instructions sont exécutées par un processeur.

L'invention sera mieux comprise en référence aux figures, lesquelles illustrent des modes de réalisation non limitatifs.

La figure 1 montre un exemple de véhicule selon un mode de réalisation de l'invention.

La figure 2 est un organigramme d'un exemple de procédé selon un mode de réalisation de l'invention.

La figure 3 représente un faisceau de courbes représentant l'évolution de la tension aux bornes de la batterie en fonction du courant pour plusieurs états de charge SOC de la batterie.

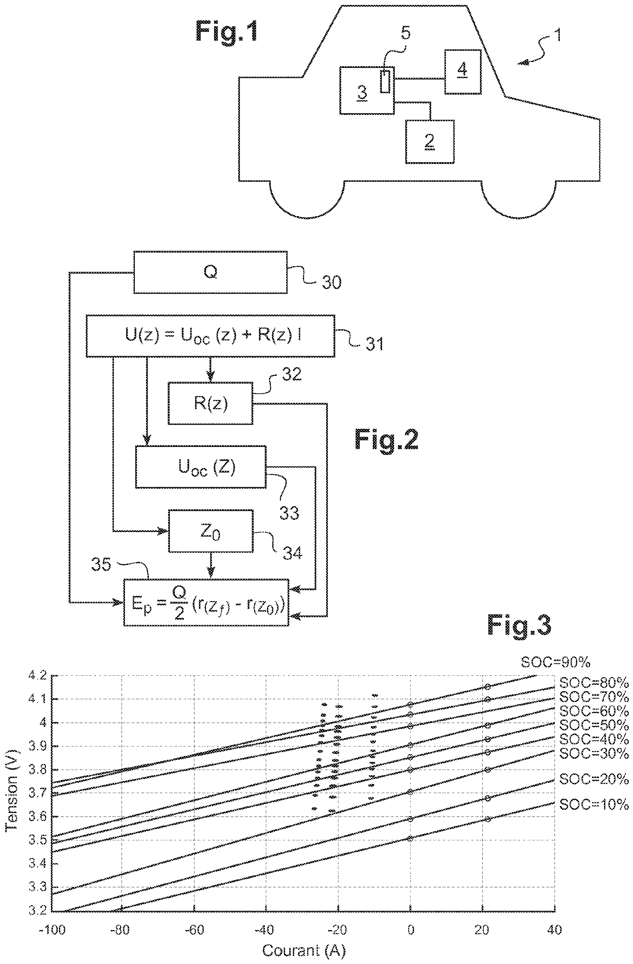

En référence à la figure 1 un véhicule automobile 1, par exemple un véhicule électrique, peut comprendre une batterie de traction 2 apte à tracter ce véhicule, un système de gestion de la batterie 3, dit BMS et une interface utilisateur 4, par exemple un tableau de bord.

Le BMS 3 permet de commander la charge et la décharge de la batterie 2, et permet de commander l'affichage de messages sur un écran (non représenté) de l'interface utilisateur 4.

Le BMS 3 intègre un dispositif 5 d'évaluation de l'énergie disponible ou de l'énergie à accumuler dans la batterie 2, par exemple une partie d'un processeur. Ce dispositif 5 peut notamment être activé lorsque l'utilisateur met le contact afin de démarrer le véhicule, et également en cours de mission, ou encore lors de phases de charge de la batterie.

Le BMS 3 est en communication avec des dispositifs de mesure de tension et de courant, par exemple un ASIC de mesure de tension cellule (ASIC : acronyme de l'anglais Application-Specific Integrated Circuit, littéralement « circuit intégré propre à une application ») et un ampèremètre non représentés.

En référence à la figure 2, un procédé selon un mode de réalisation de l'invention peut comprendre une étape 30 consistant à déterminer la capacité $Q$ de la batterie.

Cette capacité $Q$ peut par exemple être issue d'un comptage coulombique réalisé lors d'une charge partielle ou totale de la batterie au moyen d'un capteur de courant aux bornes de la batterie, ou bien de plusieurs capteurs aux bornes des cellules de la batterie, et d'une horloge. La capacité peut notamment être calculée par le BMS à partir des valeurs mesurées par les capteurs en fonction du temps de charge et éventuellement à partir d'un état de charge initial de la batterie, si ce calcul est effectué lors d'une charge partielle de la batterie.

Cette étape 30 peut être effectuée régulièrement mais pas forcément à chaque mise en route du véhicule, l'évolution de la capacité de la batterie en fonction du temps étant relativement lente, ou lors d'états particuliers de la batterie ou du véhicule. Une périodicité de plusieurs jours ou semaines peut ainsi être envisagée. Au cours d'une étape 31, notamment pendant une phase de charge, on enregistre dans une mémoire l'évolution de la tension en fonction du courant pour N états de charge $z$, ces N états de charge variant par exemple de 0 à 100%. Ces mesures peuvent être enregistrées sous forme de tables ou d'un faisceau de courbes du type représenté sur la figure 3, pour chacun des N états de charge. La figure 3 représente l'évolution de la tension U (en V) en fonction du courant I (en A) aux bornes d'une cellule faisant partie d'un pack batterie. Sur la figure 3, seules les courbes correspondant aux états de charge z=SOC allant de 10 à 90% sont représentées.

Ces tables ou courbes sont construites par le BMS à partir des valeurs mesurées par des capteurs de courant et de tension au cours de la phase de charge. Elles peuvent être construites régulièrement, par exemple à chaque charge de la batterie ou à chaque charge totale de la batterie ou à des intervalles de temps prédéterminés.

Au cours d'une étape 32, on détermine la résistance interne $R(z)$ de la batterie en fonction de l'état de charge ($z$) de la batterie à partir de la table précédemment construite à l'étape 31 et enregistrée.

En effet, la relation entre la tension $U(z)$ aux bornes de la batterie et le courant $I$ circulant au travers de la batterie peut notamment être exprimée par l'équation :

$$U(z)=Uoc(z)+R(z)I \qquad (4),$$

dans laquelle :

$U(z)$ représente la tension aux bornes de la batterie en fonction de l'état de charge z, en Volt,
$Uoc(z)$ représente la tension en circuit ouvert de la batterie en fonction de l'état de charge z, en Volt,
$I$ représente le courant traversant la batterie, en A,
$R(z)$ représente la résistance interne de la batterie en fonction de l'état de charge z, en $\Omega$,

En considérant que la résistance interne $R(z)$ de la batterie ne varie pas en charge (I>0) ou décharge (I<0) et en considérant que la valeur de la tension en circuit ouvert $Uoc$ est invariante avec la température et le vieillissement de la batterie, il est ainsi possible de déterminer la résistance interne $R(z)$ de la batterie pour chacune des N valeurs d'état de charge z à partir de la table construite à l'étape 31.

Ces N valeurs de résistance interne peuvent être déterminées par le BMS et stockées dans la mémoire.

Cette détermination de la résistance interne $R(z)$ de la batterie en fonction de l'état de charge peut être réalisée à chaque mise à jour de la table construite à la table 31, par exemple à chaque charge de la batterie.

Au cours d'une étape 33, on élabore une table de la tension en circuit ouvert *Uoc(z)* de la batterie en fonction de l'état de charge (*z*) de la batterie. Cette table est élaborée à partir de mesures expérimentales réalisées avant utilisation de la batterie dans le véhicule. A partir des N valeurs de la table construite à l'étape 33, il est possible d'approximer *Uoc(z)* soit par un polynôme d'ordre inférieur ou égal à N-1 au sens des moindres carrés, soit par une interpolation, de préférence linéaire.

On pourrait cependant également envisager d'élaborer cette table *Uoc(z)* à partir de la table construite à l'étape 31 en relevant la valeur de la tension lorsque le courant est nul pour chaque état de charge. Dans ce cas, il est préférable d'élaborer la table *Uoc(z)* lorsque l'étape 31 est mise en oeuvre au démarrage du véhicule après un long arrêt, afin d'obtenir des mesures de la tension en circuit ouvert alors que la batterie est complètement relaxée.

Au cours d'une étape 34, on estime un état de charge initial $z_0$ de la batterie à un instant initial $t_0$.

A cet effet, on peut par exemple, au cours d'une phase de décharge de la batterie, autrement dit au cours du roulage, mesurer et enregistrer un couple de valeurs de la tension et du courant (U, I) pour lequel le courant I (courant de décharge) est stable pendant une durée prédéterminée, par exemple de 10s. Par exemple, ce courant I est stable lorsqu'il ne varie pas de plus de 15% par rapport à sa valeur moyenne calculée sur cette durée de 10s. Ce point (U, I) peut être reporté dans la table ou sur les courbes construites lors de l'étape 31, ce qui permet de déduire la valeur $z_0$. Cette corrélation peut être réalisée par le BMS. Sur la figure 3, plusieurs de ces couples (U, I) sont reportés pour des valeurs de courant de décharge de 10A et 20A.

Eventuellement, l'état de charge initial $z_0$ ainsi estimé peut être comparé à un état de charge initial $z'_0$ obtenu par une autre méthode de détermination basée sur le comptage coulombique. Il est alors possible de recaler cette valeur d'état de charge initial à la valeur $z'_0$ si $z_0$ s'écarte de $z'_0$ d'une valeur prédéterminée. Des essais ont montré que la valeur d'état de charge estimée $z_0$ ne s'écarte de la valeur de l'état de charge, mesurée par comptage coulombique, que de 1% à 5% environ.

Au cours d'une étape 35, on estime par calcul une quantité d'énergie $E_p$ entre un état de charge final $z_f$ et l'état de charge initial $z_0$ précédemment estimé. A cet effet, on utilise une fonction *f(z)* dont la variable est le paramètre d'état de charge z et dont les paramètres sont la capacité Q déterminée à l'étape 30, la résistance interne *R(z)* déterminée à partir de l'étape 32 et la tension en circuit ouvert *Uoc(z)* déterminée à partir de l'étape 33.

Cette fonction *f(z)* peut alors s'écrire de la manière suivante :

$$f(z) = Uoc(z) + \sqrt{\Delta(z)} \qquad (2),$$

dans laquelle :

$\Delta(z)$ est un terme prenant en compte les pertes d'énergie, fonction de l'état de charge *z*, en V$^2$,

La quantité d'énergie $E_p$ est alors obtenue par intégration de cette fonction *f(z)* entre la valeur du paramètre d'état de charge à l'état initial (zo) et la valeur du paramètre d'état de charge à l'état final ($z_f$) définie comme étant la solution de l'équation (1) :

$$U_{final} = Uoc(z_f) + R(z_f)\frac{P}{U_{final}} \qquad (1)$$

dans laquelle :

*Uoc(z$_f$)* est la valeur du paramètre de tension en circuit ouvert de la batterie à l'état de charge final,
*R(z$_f$)* est la résistance interne de la batterie à l'état de charge final
*P* est la valeur du paramètre de puissance (constante).

La quantité d'énergie $E_p$ peut alors s'écrire:

$$E_P = \frac{Q}{2}\int_{z_0}^{z_f} f(z)dz \qquad (5),$$

dans laquelle

$E_p$ représente la quantité d'énergie, en W.h
Q représente la capacité de la batterie en A.h.

Notamment, la puissance $P$ étant constante, cette puissance est donnée par l'équation suivante :

$$P = U(t)I(t) = Uoc(z(t))I(t) + R(z(t))I(t)^2 \qquad (6)$$

Dans laquelle :

$U(t)$ représente la tension aux bornes de la batterie en fonction du temps, en V,
$I(t)$ représente le courant traversant la batterie en fonction du temps, en A,
z(t) représente l'état de charge en fonction du temps, en %,
$Uoc(z(t))$ représente la tension en circuit ouvert de la batterie en fonction de l'état de charge, en V,
$R(z(t))$ représente la résistance interne de la batterie en fonction de l'état de charge, en $\Omega$.

Cette équation (6) du 2$^{nd}$ degré en $I$ est paramétrée par l'état de charge $z$. Donc pour $z$ donné, on peut calculer $I(z)$ en résolvant cette équation (5) dont le discriminant est le terme $\Delta(z)$ de l'équation (2) et s'écrit :

$$\Delta(z) = Uoc^2(z) + 4R(z)P \qquad (7)$$

Dans un mode de réalisation avantageux, afin de simplifier l'intégration de la fonction $f(z)$ et le calcul de la quantité d'énergie, cette fonction $f(z)$ peut être approximée par un polynôme d'ordre n inférieur ou égal à N-1. La quantité d'énergie est alors exprimée par :

$$E_P \approx \frac{Q}{2}\left(r(z_f) - r(z_0)\right) \qquad (3).$$

où r(z) est la primitive dudit polynôme d'ordre n.
Plus précisément, il est proposé d'approcher $f(z)$ par un polynôme $q(z)$ au sens des moindres carrés. Notamment, si on dispose de N valeurs de $Uoc$ et de $R$ en fonction de z (par exemple d'après les étapes 32 et 33), ce polynôme $q(z)$ est alors d'ordre inférieur ou égal à N-1 et peut s'écrire :

$$q(z) = a_n z^n + a_{n-1} z^{n-1} + \cdots + a_1 z + a_0 \qquad (8)$$

dans laquelle $a_n, a_{n-1}, \ldots a_0$ sont des coefficients.
Alors

$$r(z) = \int q(z)dz = \frac{a_n}{n+1} z^{n+1} + \frac{a_{n-1}}{n} z^n + \cdots + \frac{a_1}{2} z^2 + a_0 z + k \qquad (9)$$

où $k$ est la constante d'intégration.
On notera que la puissance $P$ étant constante, il est alors possible de déterminer l'instant final $t_f$ où l'état de charge final $z_f$ est atteint par l'équation :

$$(t_f - t_0) = \frac{E_P}{P} \qquad (10).$$

La connaissance de cet instant final $t_f$ peut permettre de savoir si, en décharge, on disposera de suffisamment d'énergie pour garantir une puissance $P$ pendant une certaine durée (ex. : $P$ pendant 10s, le temps d'un dépassement de véhicule) ou de déterminer une durée de charge à puissance constante $P$, et ce quelque soit l'état de charge initial.
On notera que la connaissance de la quantité d'énergie $E_p$ permet de remonter à l'état de charge initial $z''_0$

(autrement dit de le recalculer) en résolvant l'équation (3) en $z_0$ :

$$E_P - \frac{Q}{2}\big(r(z_f) - r(z_0)\big) = 0,$$

L'état de charge final ($z_f$) étant calculé comme précédemment en résolvant (1).

Cette état de charge initial recalculé $z''_0$ peut servir à la déterminer une nouvelle quantité d'énergie $E_{P2}$ correspondant à une puissance constante $P_2$ différente de la puissance précédemment utilisée pour déterminer $E_p$.

On notera enfin que les étapes 30, 31 et 33 du procédé peuvent être réitérées indépendamment les unes des autres et indépendamment de la réitération des étapes 34 et 35. Selon les variantes, les étapes 32 et 33 pourront être mises en oeuvre à chaque réitération de l'étape 31.

La réitération de l'étape 30 et de l'étape 32 permet une prise en compte de l'évolution de la capacité de la batterie et de sa résistance interne lors du vieillissement de la batterie, pouvant permettre une meilleure estimation de la quantité d'énergie.

Le procédé décrit dans la présente invention présente en outre l'avantage de pouvoir s'appliquer aussi bien à la gestion de la charge de la batterie qu'à la gestion de sa décharge et permet notamment d'estimer le temps de charge restant lors d'une charge à puissance constante.

## Revendications

1. Procédé d'évaluation d'une quantité d'énergie à puissance constante d'une batterie de véhicule automobile, ladite quantité d'énergie correspondant à une quantité d'énergie extractible ou à une quantité d'énergie à accumuler, ledit procédé comprenant :

    (a) déterminer (30) une valeur d'un paramètre de capacité $Q$ de la batterie,
    (b) construire (31), notamment pendant une phase de charge de la batterie, une table de valeurs d'un paramètre de tension aux bornes de la batterie en fonction de la valeur d'un paramètre de courant pour N valeurs d'un paramètre d'état de charge ($z$),
    (c) déterminer (32) une valeur d'un paramètre de résistance interne $R(z)$ de la batterie en fonction d'un paramètre d'état de charge ($z$) de ladite batterie à partir de la table construite à l'étape (b),
    (d) prévoir (33) une table de valeurs d'un paramètre de tension en circuit ouvert $Uoc(z)$ de la batterie en fonction du paramètre d'état de charge ($z$) de la batterie,
    (e) estimer (34) une valeur du paramètre d'état de charge ($z_0$) de la batterie à un instant initial $t_0$, correspondant à un état de charge initial de la batterie,
    (f) estimer (35) par calcul une valeur de paramètre de quantité d'énergie $E_p$ entre un état de charge final et ledit état de charge initial en utilisant une fonction $f(z)$ dont la variable est le paramètre d'état de charge ($z$) et dont les paramètres sont ladite valeur du paramètre de capacité Q de la batterie, ladite valeur du paramètre de résistance interne $R(z)$ et ladite valeur du paramètre de tension en circuit ouvert $Uoc(z)$.

2. Procédé selon la revendication 1, dans lequel la fonction $f(z)$ utilisée dans l'étape (f) d'estimation de la quantité d'énergie s'écrit :

$$f(z) = Uoc(z) + \sqrt{\Delta(z)} \quad (2),$$

dans laquelle :

    $\Delta(z)$ est un terme prenant en compte les pertes d'énergie, fonction de la valeur du paramètre d'état de charge ($z$),
    $Uoc(z)$ représente le paramètre de tension en circuit ouvert en fonction de la valeur du paramètre d'état de charge ($z$),

et la valeur du paramètre de quantité d'énergie est obtenue par intégration de ladite fonction entre la valeur du paramètre d'état de charge à l'état initial ($z_0$) et la valeur du paramètre d'état de charge à l'état final ($z_f$), ladite valeur du paramètre d'état de charge final ($z_f$) étant la solution de l'équation :

$$U_{final} = Uoc(z_f) + R(z_f)\frac{P}{U_{final}} \quad (1)$$

dans laquelle :

$U_{final}$ représente le paramètre de tension aux bornes de la batterie à l'état de charge final ($z_f$)
$R(z_f)$ représente le paramètre de résistance interne de la batterie à l'état de charge final ($z_f$)
$Uoc(z_f)$ représente le paramètre de tension en circuit ouvert en fonction de la valeur du paramètre d'état de charge final ($z_f$).
$P$ est la valeur constante du paramètre de puissance.

3. Procédé selon la revendication 2, dans lequel la fonction $f(z)$ est approximée par un polynôme d'ordre n inférieur ou égal à N-1 et ladite valeur de paramètre de quantité d'énergie $E_p$ est exprimée par :

$$E_P \approx \frac{Q}{2}\big(r(z_f) - r(z_0)\big) \quad (3).$$

dans laquelle :

$r(z)$ est l'intégrale dudit polynôme d'ordre n
$Q$ représente le paramètre de capacité

4. Procédé selon l'une des revendications 1 à 3, dans lequel les étapes (a) et (b) sont réitérées au cours de la vie de la batterie, indépendamment l'une de l'autre et des étapes (e) et (f) dudit procédé.

5. Procédé selon l'une quelconque des revendications 1 à 4, dans lequel l'étape (e) d'estimation de la valeur du paramètre d'état de charge initial ($z_0$) comprend, à l'instant initial $t_0$ :

(i) mesurer la valeur du paramètre de tension aux bornes de la batterie et la valeur du paramètre de courant circulant dans la batterie lorsque ladite valeur du paramètre de courant est stable pendant une durée prédéterminée au cours d'une phase de décharge de la batterie,
(ii) en déduire la valeur du paramètre d'état de charge initial ($z_0$) à partir de la table construite à l'étape (b).

6. Procédé selon la revendication 5, dans lequel l'étape (e) comprend les étapes supplémentaires suivantes :

(iii) estimer une deuxième valeur du paramètre d'état de charge initial ($z'_0$) par une autre méthode de prédiction,
(iv) comparer la première valeur du paramètre d'état de charge initial ($z_0$) déterminée à l'étape (ii) avec la deuxième valeur du paramètre d'état de charge initial ($z'_0$) déterminée à l'étape (iii),
(v) utiliser la valeur du paramètre d'état de charge initial ($z_0$) déterminée à l'étape (ii) si la différence $z_0$-$z'_0$ est inférieure à une valeur prédéterminée, sinon, utiliser la deuxième valeur du paramètre d'état de charge initial ($z'_0$) déterminée à l'étape (iii).

7. Procédé selon l'une des revendications 1 à 6, lequel comprend, après l'étape (f), l'étape supplémentaire suivante :

(g) déterminer une nouvelle valeur du paramètre d'état de charge initial ($z''_0$) en utilisant la valeur de paramètre de quantité d'énergie $E_p$ estimée à l'étape (f).

8. Procédé selon la revendication 7, dans lequel les étapes (e) à (g) peuvent être mise en oeuvre pour une première valeur de paramètre de puissance $P_1$, puis l'étape (f) peut être mise en oeuvre pour une deuxième valeur de paramètre de puissance $P_2$ en utilisant la valeur du paramètre d'état de charge initial ($z''_0$) déterminée à l'étape (g).

9. Dispositif d'évaluation (5) d'une quantité d'énergie d'une batterie de véhicule automobile à puissance constante, ladite quantité d'énergie correspondant à une quantité d'énergie extractible ou à une quantité d'énergie à accumuler, comprenant :

- des moyens de réception aptes à recevoir différentes valeurs de paramètres dont une valeur d'un paramètre de tension aux bornes de la batterie, une valeur d'un paramètre de courant, et éventuellement une valeur de paramètre de temps, **caractérisé par**

- des moyens agencés pour stocker les valeurs reçues par les moyens de réception et stocker une table de valeurs d'un paramètre de tension aux bornes de la batterie en fonction de la valeur d'un paramètre de courant pour N valeurs d'un paramètre d'état de charge ($z$) de ladite batterie et une table de valeurs d'un paramètre de tension en circuit ouvert $Uoc(z)$ de la batterie en fonction du paramètre d'état de charge ($z$) de la batterie,
- des moyens de traitement agencés pour

   - déterminer une valeur d'un paramètre de capacité $Q$ de la batterie,
   - construire une table de valeurs d'un paramètre de tension aux bornes de la batterie en fonction de la valeur d'un paramètre de courant pour N valeurs d'un paramètre d'état de charge ($z$) de ladite batterie,
   - déterminer une valeur d'un paramètre de résistance interne $R(z)$ de la batterie en fonction dudit paramètre d'état de charge ($z$) de ladite batterie à partir de la table construite,
   - estimer une valeur du paramètre d'état de charge ($z_0$) de la batterie à un instant initial $t_0$, correspondant à un état de charge initial de la batterie, notamment en fonction de la table stockée dans les moyens de stockage, et
   - estimer par calcul une valeur de paramètre de quantité d'énergie $E_p$ entre un état de charge final et ledit état de charge initial en utilisant une fonction $f(z)$ dont la variable est le paramètre d'état de charge ($z$) et dont les paramètres sont ladite valeur du paramètre de capacité $Q$ de la batterie, ladite valeur du paramètre de résistance interne $R(z)$ et ladite valeur de la tension en circuit ouvert $Uoc(z)$.

**10.** Véhicule automobile (1) comprenant une batterie (2) et un dispositif (5) selon la revendication 9 d'évaluation d'une quantité d'énergie de ladite batterie à puissance constante.

## Patentansprüche

**1.** Verfahren zur Beurteilung einer Energiemenge bei konstanter Leistung einer Kraftfahrzeugbatterie, wobei die Energiemenge einer extrahierbaren Energiemenge oder einer zu speichernden Energiemenge entspricht, wobei das Verfahren umfasst:

   (a) Bestimmung (30) eines Werts eines Kapazitätsparameters Q der Batterie,
   (b) Erstellung (31), insbesondere während einer Ladephase der Batterie, einer Tabelle von Werten eines Spannungsparameters an den Klemmen der Batterie in Abhängigkeit von dem Wert eines Stromparameters für N Werte eines Ladezustandsparameters (z),
   (c) Bestimmung (32) eines Werts eines internen Widerstandsparameters R(z) der Batterie in Abhängigkeit von einem Ladezustandsparameter (z) der Batterie auf Basis der in Schritt (b) erstellten Tabelle,
   (d) Vorsehen (33) einer Tabelle von Werten eines Leerlaufspannungsparameters Uoc(z) der Batterie in Abhängigkeit von dem Ladezustandsparameter (z) der Batterie,
   (e) Schätzen (34) eines Werts des Ladezustandsparameters ($z_0$) der Batterie zu einem Anfangszeitpunkt $t_0$ entsprechend einem Anfangsladezustand der Batterie,
   (f) Schätzen (35) des Werts des internen Widerstandsparameters R(z) und des Werts des Leerlaufspannungsparameters Uoc(z) durch Berechnung eines Werts eines Parameters einer Energiemenge $E_p$ zwischen einem Endladezustand und dem Anfangsladezustand unter Verwendung einer Funktion f(z), deren Variable der Ladezustandsparameter (z) ist, und deren Parameter der Wert des Kapazitätsparameters Q der Batterie sind.

**2.** Verfahren nach Anspruch 1, bei dem die Funktion f(z), die in dem Schritt (f) der Schätzung der Energiemenge verwendet wird, folgendermaßen geschrieben ist:

$$f(z) = Uoc(z) + \sqrt{\Delta(z)} \quad (2),$$

wobei:

$\Delta(z)$ ein Term ist, der die Energieverluste in Abhängigkeit vom Wert des Ladezustandsparameters (z) berücksichtigt,
Uoc(z) den Leerlaufspannungsparameter in Abhängigkeit vom Wert des Ladezustandsparameters (z) darstellt,

und der Wert des Parameters der Energiemenge durch Integration der Funktion zwischen dem Wert des Ladezustandsparameters im Anfangszustand ($z_0$) und dem Wert des Ladezustandsparameters im Endzustand ($z_f$) erhalten wird, wobei der Wert des Endladzustandsparameters ($z_f$) die Lösung der folgenden Gleichung ist:

$$U_{final} = Uoc(z_f) + R(z_f)\frac{P}{U_{final}} \quad (1)$$

wobei:

$U_{final}$ den Spannungsparameter an den Klemmen der Batterie im Endladezustand ($z_f$) darstellt,
$R(z_f)$ den internen Widerstandsparameter der Batterie im Endladezustand ($z_f$) darstellt,
$Uoc(z_f)$ den Leerlaufspannungsparameter in Abhängigkeit vom Wert des Endladezustandsparameters ($z_f$) darstellt,
P der konstante Wert des Leistungsparameters ist.

3. Verfahren nach Anspruch 2, bei dem die Funktion f(z) durch ein Polynom der Ordnung n kleiner oder gleich N-1 angenähert wird, und der Wert des Parameters der Energiemenge $E_p$ ausgedrückt wird durch:

$$E_P \approx \frac{Q}{2}\big(r(z_f) - r(z_0)\big) \quad (3)$$

wobei:

r(z) das Integral des Polynoms der Ordnung n ist,
Q den Kapazitätsparameter darstellt.

4. Verfahren nach einem der Ansprüche 1 bis 3, bei dem die Schritte (a) und (b) während der Lebensdauer der Batterie unabhängig voneinander und von den Schritten (e) und (f) des Verfahrens reiteriert werden.

5. Verfahren nach einem der Ansprüche 1 bis 4, bei dem der Schritt (e) der Schätzung des Werts des Anfangsladezustandsparameters ($z_0$) zum Anfangszeitpunkt $t_0$ umfasst:

(i) Messen des Werts des Spannungsparameters an den Klemmen der Batterie und des Werts des in der Batterie zirkulierenden Stroms, wenn der Wert des Stromparameters während einer vorbestimmten Dauer während einer Entladephase der Batterie stabil ist,
(ii) davon Abzug des Werts des Anfangsladezustandsparameters ($z_0$) auf Basis der in Schritt (b) erstellten Tabelle.

6. Verfahren nach Anspruch 5, bei dem der Schritt (e) die folgenden zusätzlichen Schritte umfasst:

(iii) Schätzen eines zweiten wertes des Anfangsladezustandsparameters ($z'_0$) durch eine andere Vorhersagemethode,
(iv) Vergleichen des ersten Werts des in Schritt (ii) bestimmten Anfangsladezustandsparameters ($z_0$) mit dem zweiten Wert des in Schritt (iii) bestimmten Anfangsladezustandsparameters ($z'_0$),
(v) Verwendung des Werts des in Schritt (ii) bestimmten Anfangsladezustandsparameters ($z_0$), wenn die Differenz $z_0$-$z'_0$ kleiner als ein vorbestimmter Wert ist, anderenfalls Verwendung des zweiten Werts des in Schritt (iii) bestimmten Anfangsladezustandsparameters ($z'_0$).

7. Verfahren nach einem der Ansprüche 1 bis 6, das nach dem Schritt (f) den folgenden zusätzlichen Schritt umfasst:

(g) Bestimmung eines neuen Werts des Anfangszustandsparameters ($z''_0$) unter Verwendung des Werts des Parameters der in Schritt (f) geschätzten Energiemenge $E_p$.

8. Verfahren nach Anspruch 7, bei dem die Schritte (e) bis (g) für einen ersten Wert eines Leistungsparameters $P_1$ eingesetzt werden können, dann der Schritt (f) für einen zweiten Wert eines Leistungsparameters $P_2$ unter Verwendung des Werts das in Schritt (g) bestimmten Anfangsladezustandsparameters ($z''_0$) eingesetzt werden kann.

9. Vorrichtung (5) zur Beurteilung einer Energiemenge einer Kraftfahrzeugbatterie bei konstanter Leistung, wobei die Energiemenge einer extrahierbaren Energiemenge oder einer zu speichernden Energiemenge entspricht, umfassend:

   - Empfangsmittel, die geeignet sind, verschiedene Werte von Parametern zu empfangen, darunter einen Wert eines Spannungsparameters an den Klemmen der Batterie, einen Wert eines Stromparameters und eventuell einen Wert eines Zeitparameters,

   **gekennzeichnet durch**:

   - Mittel, die eingerichtet sind, die von den Empfangsmitteln empfangenen Werte zu speichern und eine Tabelle von Werten eines Spannungsparameters an den Klemmen der Batterie in Abhängigkeit von dem Wert eines Stromparameters für N Werte eines Ladezustandsparameters (z) der Batterie und eine Tabelle von Werten eines Leerlaufspannungsparameters Uoc(z) der Batterie in Abhängigkeit von dem Ladezustandsparameter (z) der Batterie zu speichern,
   - Bearbeitungsmittel, die eingerichtet sind, um

      - einen Wert eines Kapazitätsparameters Q der Batterie zu bestimmen,
      - eine Tabelle von Werten eines Spannungsparameters an den Klemmen der Batterie in Abhängigkeit von dem Wert eines Stromparameters für N Werte eines Ladezustandsparameters (z) zu erstellen,
      - einen Wert eines internen Widerstandsparameters R(z) der Batterie in Abhängigkeit von dem Ladezustandsparameter (z) der Batterie auf Basis der erstellten Tabelle zu bestimmen,
      - einen Wert des Ladezustandsparameters ($z_0$) der Batterie zu einem Anfangszeitpunkt $t_0$ entsprechend einem Anfangsladezustand der Batterie insbesondere in Abhängigkeit von der in den Speichermitteln gespeicherten Tabelle zu schätzen, und
      - einen Wert des internen Widerstandsparameters R(z) und des Werts des Leerlaufspannungsparameters Uoc(z) durch Berechnung eines Werts eines Parameters einer Energiemenge $E_p$ zwischen einem Endladezustand und dem Anfangsladezustand unter Verwendung einer Funktion f(z), deren Variable der Ladezustandsparameter (z) ist, und deren Parameter der Wert des Kapazitätsparameters Q der Batterie sind, zu schätzen.

10. Kraftfahrzeug (1), umfassend eine Batterie (2) und eine Vorrichtung (5) nach Anspruch 9 zur Beurteilung einer Energiemenge der Batterie bei konstanter Leistung.

**Claims**

1. Method for evaluating a quantity of energy at constant power of a battery of an automobile vehicle, said quantity of energy corresponding to an extractible quantity of energy or to a quantity of energy to be accumulated, said method comprising:

   (a) determine (30) a value of a capacity parameter Q for the battery,
   (b) construct (31), notably during a charge phase of the battery, a table of values for a parameter of voltage across the terminals of the battery as a function of the value of a current parameter for N values of a state of charge parameter (z),
   (c) determine (32) a value of an internal resistance parameter $R(z)$ for the battery as a function of a state of charge parameter (z) for said battery based on the table constructed at the step (b),
   (d) provide (33) a table of values of an open-circuit voltage parameter $Uoc(z)$ for the battery as a function of the state of charge parameter (z) for the battery,
   (e) estimate (34) a value of the state of charge parameter ($z_0$) for the battery at an initial time $t_0$, corresponding to an initial state of charge of the battery,
   (f) estimate (35) by calculation a value of a quantity of energy parameter $E_p$ between a final state of charge and said initial state of charge using a function $f(z)$ whose variable is the state of charge parameter (z) and whose parameters are said value of the capacity parameter $Q$ for the battery, said value of the internal resistance parameter $R(z)$ and said value of the open-circuit voltage parameter $Uoc(z)$.

2. Method according to Claim 1, in which the function $f(z)$ used in the step (f) for estimating the quantity of energy is written:

$$f(z) = Uoc(z) + \sqrt{\Delta(z)} \quad (2),$$

in which:

$\Delta(z)$ is a term taking into account the energy losses, being a function of the value of the state of charge parameter ($z$),

$Uoc(z)$ represents the open-circuit voltage parameter as a function of the value of the state of charge parameter ($z$),

and the value of the quantity of energy parameter is obtained by integration of said function between the value of the state of charge parameter in the initial state ($z_0$) and the value of the state of charge parameter in the final state ($z_f$), said value of the final state of charge parameter ($z_f$) being the solution of the equation:

$$U_{final} = Uoc(z_f) + R(z_f)\frac{P}{U_{final}} \quad (1)$$

in which:

$U_{final}$ represents the parameter of voltage across the terminals of the battery in the final state of charge ($z_f$)

$R(z_f)$ represents the internal resistance parameter of the battery in the final state of charge ($z_f$)

$Uoc(z_f)$ represents the open-circuit voltage parameter as a function of the value of the final state of charge parameter ($z_f$).

P is the constant value of the power parameter.

3. Method according to Claim 2, in which the function $f(z)$ is approximated by a polynomial of order n less than or equal to N-1 and said value of quantity of energy parameter $E_p$ is expressed by:

$$E_P \approx \frac{Q}{2}\left(r(z_f) - r(z_0)\right) \quad (3).$$

in which:

$r(z)$ is the integral of said polynomial of order n
$Q$ represents the capacity parameter

4. Method according to one of Claims 1 to 3, in which the steps (a) and (b) are iterated over the lifetime of the battery, independently of each other and of the steps (e) and (f) of said method.

5. Method according to any one of Claims 1 to 4, in which the step (e) for estimating the value of the initial state of charge parameter ($z_0$) comprises, at the initial time $t_0$:

(i) measuring the value of the parameter of voltage across the terminals of the battery and the value of the parameter of current flowing in the battery when said value of the current parameter is stable for a predetermined period of time during a discharge phase of the battery,
(ii) deducing from this the value of the initial state of charge parameter ($z_0$) based on the table constructed at the step (b).

6. Method according to Claim 5, in which the step (e) comprises the following additional steps:

(iii) estimate a second value of the initial state of charge parameter ($z'_0$) by another prediction method,
(iv) compare the first value of the initial state of charge parameter ($z_0$) determined at the step (ii) with the second value of the initial state of charge parameter ($z'_0$) determined at the step (iii),
(v) use the value of the initial state of charge parameter ($z_0$) determined at the step (ii) if the difference $z_0 - z'_0$ is less than a predetermined value, otherwise, use the second value of the initial state of charge parameter ($z'_0$)

determined at the step (iii).

7. Method according to one of Claims 1 to 6, which comprises, after the step (f), the following additional step:

(g) determine a new value of the initial state of charge parameter ($z''_0$) using the value of quantity of energy parameter $E_p$ estimated at the step (f).

8. Method according to Claim 7, in which the steps (e) to (g) may be implemented for a first value of power parameter $P_1$, then the step (f) may be implemented for a second value of power parameter $P_2$ using the value of the initial state of charge parameter ($z''_0$) determined at the step (g).

9. Device for evaluating (5) a quantity of energy of a battery of an automobile vehicle at constant power, said quantity of energy corresponding to an extractible quantity of energy or to a quantity of energy to be accumulated, comprising:

- receiving means designed to receive various values of parameters including a value of a parameter of voltage across the terminals of the battery, a value of a current parameter, and potentially a value of a time parameter,

**characterized by**:

- means arranged for storing the values received by the receiving means and storing a table of values of a parameter of voltage across the terminals of the battery as a function of the value of a current parameter for N values of a state of charge parameter (z) of said battery and a table of values of an open-circuit voltage parameter $Uoc(z)$ for the battery as a function of the state of charge parameter (z) for the battery,
- processing means arranged for

- determining a value of a capacity parameter $Q$ for the battery,
- constructing a table of values of a parameter of voltage across the terminals of the battery as a function of the value of a current parameter for N values of a state of charge parameter (z) for said battery,
- determining a value of an internal resistance parameter $R(z)$ for the battery as a function of said state of charge parameter (z) for said battery using the table constructed,
- estimating a value of the state of charge parameter ($z_0$) for the battery at an initial time $t_0$, corresponding to an initial state of charge of the battery, notably as a function of the table stored in the storage means, and
- estimating by calculation a value of quantity of energy parameter $E_p$ between a final state of charge and said initial state of charge using a function $f(z)$ whose variable is the state of charge parameter (z) and whose parameters are said value of the capacity parameter $Q$ for the battery, said value of the internal resistance parameter $R(z)$ and said value of the open-circuit voltage $Uoc(z)$.

10. Automobile vehicle (1) comprising a battery (2) and a device (5) according to Claim 9 for evaluating a quantity of energy for said battery at constant power.

## Fig.1

## Fig.2

$$Q \quad \sim 30$$

$$U(z) = U_{oc}(z) + R(z) I \quad \sim 31$$

$$R(z) \quad \sim 32$$

$$U_{oc}(Z)$$

$$33$$

$$Z_0 \quad 34$$

$$35 \quad E_p = \frac{Q}{2}\left(r_{(Z_f)} - r_{(Z_0)}\right)$$

## Fig.3

**EP 3 079 940 B1**

## RÉFÉRENCES CITÉES DANS LA DESCRIPTION

**Documents brevets cités dans la description**

- US 2013041538 A1
- US 2006202663 A1